# EUROPEAN PATENT APPLICATION

(11) **EP 2 746 975 A1**
(43) Date of publication of application: **25.06.2014**
(21) Application number: 13198348.8
(22) Date of filing: 19.12.2013
(51) Int. Cl.: G06F 17/50

(54) **CAD drawing notes manager**

(30) Priority: 19.12.2012 US 201213720225
(71) Applicant: Sikorsky Aircraft Corporation, Stratford, CT 06615 (US)
(72) Inventor: Marchesseault, Brian David, Milford, CT 06460 (US)
(74) Representative: Klunker . Schmitt-Nilson . Hirsch

(57) **Abstract**

Embodiments are directed to processing, by a computing device comprising a processor, a drawing sheet in accordance with a file structure, wherein the drawing sheet comprises a note including a graphic, extracting, by the computing device, data from the drawing sheet based on the processing, the data comprising a representation of the graphic included in the note, and loading, by the computing device, the data into at least one of a product lifecycle management tool and a product data management tool.

## Description

The present invention generally relates to CAD/PLM tools.

Computer aided design or computer aided drawing tools, either or both of which may be referred to as so-called CAD tools, permit a user to define graphical notes and/or textual notes on drawing sheets. The notes may convey engineering details. The CAD tools generally do not store the notes in a structured manner to facilitate data mining or other applications or analysis of the notes.

Product lifecycle management tools or product data management tools, either or both of which may be referred to as so-called PLM tools, are used to store bill of material (BOM) and related metadata in a structured manner. PLM tools generally do not permit the inclusion of graphical content in-context as part of the data. Accordingly, there is a potential disconnect in terms of data when using CAD and PLM tools, as notes included on CAD drawing sheets reside in parallel to, yet are "physically" disconnected from, data and related metadata resident in PLM tools.

An embodiment of the disclosure is directed to a method comprising: processing, by a computing device comprising a processor, a drawing sheet in accordance with a file structure, wherein the drawing sheet comprises a note including a graphic, extracting, by the computing device, data from the drawing sheet based on the processing, the data comprising a representation of the graphic included in the note, and loading, by the computing device, the data into at least one of a product lifecycle management tool and a product data management tool.

Particular embodiments may include any of the following optional features, alone or in combination:

The method further may comprise generating, by the computing device, the drawing sheet using at least one of a computer aided design tool and a computer aided drawing tool (CAD tool); and causing, by the computing device, the drawing sheet to be output to at least one output device.

The file structure may adhere to a Multipurpose Internet Mail Extensions Hypertext Markup Language (MHTML) file format.

The MHTML format may be extended to comprise a structured PLM-focused extensible markup language (XML) data island.

The method further may comprise comparing, by the computing device, the loaded data against the note in the drawing sheet; and providing, by the computing device, an indication of whether the loaded data matches the note in the drawing sheet within a threshold based on the comparison.

The note may include at least one of a textual note and an annotation, and wherein the data comprises a representation of the at least one of the textual note and the annotation.

The at least one of the textual note and the annotation may comprise at least one of an engineering finish and an inspection requirement.

An embodiment of the disclosure is directed to an apparatus comprising: at least one processor, and memory having instructions stored thereon that, when executed by the at least one processor, cause the apparatus to: process a drawing sheet in accordance with a file structure, wherein the drawing sheet comprises a note including a graphic, extract data from the drawing sheet based on the processing, the data comprising a representation of the graphic included in the note, and load the data into at least one of a product lifecycle management tool and a product data management tool.

Particular embodiments may include any of the following optional features, alone or in combination:

The apparatus further may comprise a user interface configured to receive input to generate the drawing sheet.

The user interface may be configured to support at least one of a computer aided design tool and a computer aided drawing tool (CAD tool) to receive the input. The instructions, when executed by the at least one processor, may cause the apparatus to output the drawing sheet to an output device associated with the user interface.

The file structure may adhere to a Multipurpose Internet Mail Extensions Hypertext Markup Language (MHTML) file format.

The MHTML format may be extended to comprise a structured extensible markup language (XML) data island.

The instructions, when executed by the at least one processor, may cause the apparatus to access the data from one of the product lifecycle management tool and the product data management tool to perform at least one of data mining and automated error checking.

The note may include at least one of a textual note and an annotation, and wherein the data comprises a representation of the at least one of the textual note and the annotation.

An embodiment of the disclosure is directed to a non-transitory computer-readable medium comprising instructions that, when executed, cause an apparatus to: process a drawing sheet in accordance with a file structure, wherein the drawing sheet comprises a note including a graphic, extract data from the drawing sheet based on the processing, the data comprising a representation of the graphic included in the note, and load the data into at least one of a product lifecycle management tool and a product data management tool.

Particular embodiments may include any of the following optional features, alone or in combination:

The instructions, when executed, may cause the apparatus to generate the drawing sheet using at least one of a computer aided design tool and a computer aided drawing tool (CAD tool) based on input received from a user via an interface.

The note may include at least one of a textual note and an annotation. The data may comprise a representation of the at least one of the textual note and the annotation.

The instructions, when executed, may cause the apparatus to perform a data mining of a database based on the loaded data; and populate a second drawing sheet with the note based on the data mining.

The instructions, when executed, may cause the apparatus to perform a search of a database for the note based on the loaded data; and output an identification of one or more instances where the note appears.

Additional embodiments are described below.

The present disclosure is illustrated by way of example and not limited in the accompanying figures in which like reference numerals indicate similar elements.
FIG. 1 is a schematic block diagram illustrating an exemplary computing system in accordance with one or more aspects of this disclosure;
FIG. 2 illustrates an exemplary drawing sheet;
FIG. 3 illustrates an exemplary listing;
FIG. 4 illustrates an exemplary file structure in accordance with one or more embodiments of the disclosure;
FIG. 5 illustrates an exemplary drawing sheet in accordance with one or more embodiments of the disclosure;
FIG. 6 illustrates an exemplary structured file in accordance with one or more embodiments of the disclosure; and
FIG. 7 illustrates a flow chart of an exemplary method in accordance with one or more embodiments of the disclosure.

It is noted that various connections are set forth between elements in the following description and in the drawings (the contents of which are included in this disclosure by way of reference). It is noted that these connections in general and, unless specified otherwise, may be direct or indirect and that this specification is not intended to be limiting in this respect. In this respect, a coupling between entities may refer to either a direct or an indirect connection.

Exemplary embodiments of apparatuses, systems, and methods are described for bridging a gap between CAD and PLM tools. In some embodiments, notes (e.g., textual notes, graphical notes, annotations, etc.) included on drawing sheets (e.g., CAD drawing sheets) may be captured, while also structuring the associated data for loading into one or more PLM tools. The loading into the PLM tool(s) may facilitate data mining, automated checking (e.g., automated error checking), business intelligence, or other functionalities. In some embodiments, a drawing notes manager (DNM) tool may be implemented to facilitate the capture or structuring of data. The DNM tool may be implemented as a NET application.

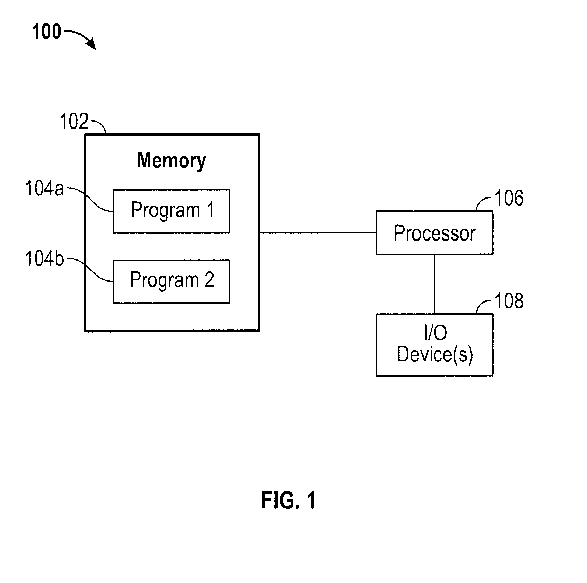

Referring to FIG. 1, an exemplary computing system 100 is shown. The system 100 is shown as including a memory 102. The memory 102 may store executable instructions. The executable instructions may be stored or organized in any manner and at any level of abstraction, such as in connection with one or more processes, routines, procedures, methods, etc. As an example, at least a portion of the instructions are shown in FIG. 1 as being associated with a first program 104a and a second program 104b.

The instructions stored in the memory 102 may be executed by one or more processors, such as a processor 106. The processor 106 may be coupled to one or more input/output (I/O) devices 108. In some embodiments, the I/O device(s) 108 may include one or more of a keyboard or keypad, a touchscreen or touch panel, a display screen, a microphone, a speaker, a mouse, a button, a remote control, a joystick, a printer, a telephone or mobile device (e.g., a smartphone), etc. The I/O device(s) 108 may be configured to provide an interface to allow a user to interact with the system 100.

The system 100 is illustrative. In some embodiments, one or more of the entities may be optional. In some embodiments, additional entities not shown may be included. For example, in some embodiments the system 100 may be associated with one or more networks. In some embodiments, the entities may be arranged or organized in a manner different from what is shown in FIG. 1. One or more of the entities shown in FIG. 1 may be associated with one or more of the devices or entities described herein.

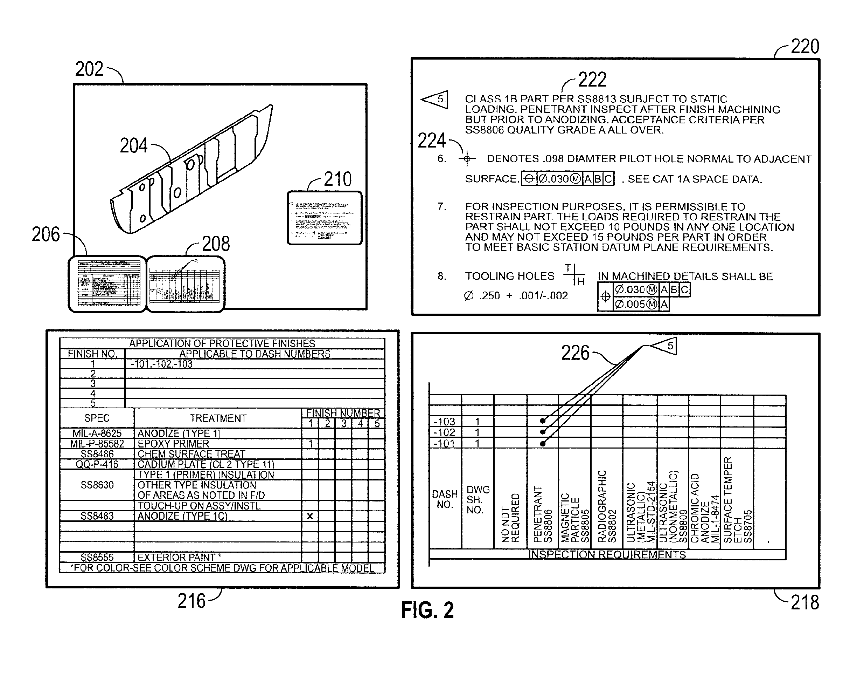

FIG. 2 illustrates an exemplary drawing sheet 202 in accordance with one or more embodiments of the disclosure. The drawing sheet 202 may have been generated using one or more applications or tools, such as one or more CAD tools. The drawing sheet 202 may be associated with one or more products or services. For example, the drawing sheet 202 may have been generated so as to capture engineering details for designing, fabricating, assembling, testing, or using a product 204.

In order to improve or enhance the quality (e.g., the engineering quality) of the drawing sheet 202, the drawing sheet 202 may include one or more notes (e.g., engineering notes), such as notes indicated by boxes 206, 208, and 210. Box 216 represents a blown-up or closer view of the box 206. Box 218 represents a blown-up or closer view of the box 208. Box 220 represents a blown-up or closer view of the box 210.

The particular contents or details associated with the notes or boxes 206/216, 208/218, and 210/220 are for illustrative purposes, and a skilled artisan would appreciate that different content may be used in connection with various products or services. As shown in FIG. 2, each of the notes 206/216, 208/218, and 210/220 may include one or more of textual notes, graphical notes, annotations, etc., that are relevant to a product (e.g., the product 204) depicted on a drawing sheet (e.g., the drawing sheet 202). For example, shown in FIG. 2 are text notes 222, graphical notes 224, and annotations 226.

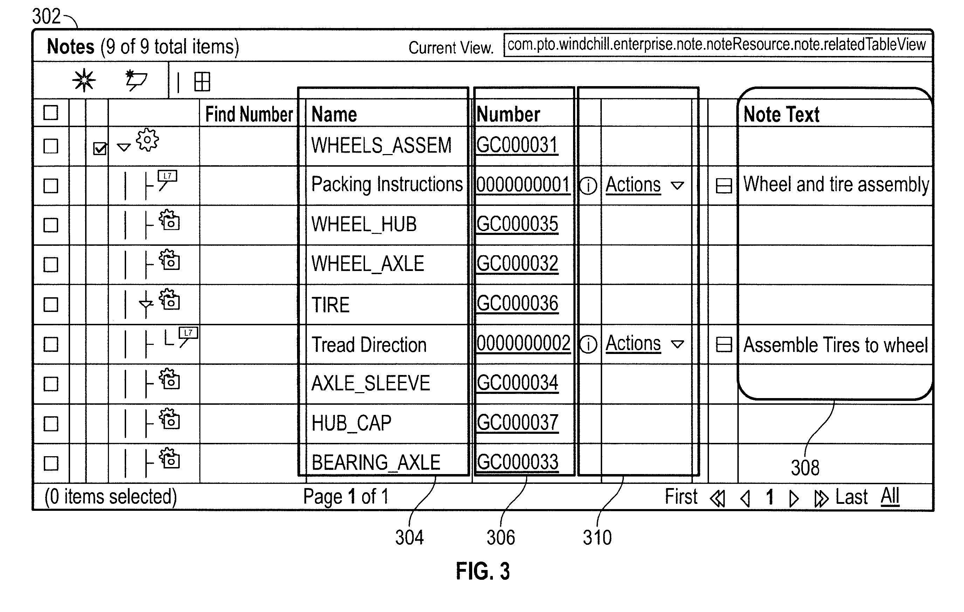

FIG. 3 illustrates an exemplary listing 302 in accordance with one or more embodiments of the disclosure. The listing 302 may include data that may be generated by one or more PLM tools. The listing 302 may be used by, e.g., purchasing or inventory personnel to ensure that a sufficient number of components or devices are available to satisfy a BOM for the product 204 of FIG. 2.

The listing 302 may include a number of fields. For example, as highlighted in FIG. 2, the listing 302 may include names of components, devices, or instructions 304. Each of the listed items 304 may have a corresponding part, reference, or document number 306. In some instances, one or more of the items 304 may have corresponding textual notes 308. In some instances, one or more of the items 304 may be associated with an action 310, which may be implemented as a drop-down list of choices.

The listing 302 shown in FIG. 3 does not include graphical content or annotations. For example, graphical content and annotations included in the notes 206/216, 208/218, and 210/220 of FIG. 2 is not shown or represented in the listing 302.

Embodiments of the disclosure may be used to bridge the gap between a drawing sheet (e.g., the drawing sheet 202) and a listing (e.g., the BOM listing 302). In particular, graphical notes and annotations included in a drawing sheet may be incorporated into a listing in accordance with one or more embodiments. In some embodiments, the incorporation of the graphical content or annotations into the listing may be used to conduct searches for specification and/or material callouts made on a drawing sheet that may be associated with materials of concern.

In some embodiments, a drawing notes manager (DNM) tool may permit an authoring of drawing sheets containing notes with "all-in-one" text and graphics, similar to the drawing sheet 202 of FIG. 2. The DNM tool may be implemented on a system 100 as shown in FIG. 1. The DNM tool may store the associated notes in a structured file (e.g., an extensible markup language (XML) file) within a DNM file, which may allow for extraction of the notes to PLM data structures. In this manner, notes from a drawing sheet may appear in PLM data structures.

In some embodiments, the DNM tool may leverage one or more formats, such as the internet standard (RFC 2557) Web Archive (Multipurpose Internet Mail Extensions (MIME) Hypertext Markup Language (MHTML) or "mht") file format, which may provide support for combined graphics and text. In some embodiments, the format (e.g., the mht format) may be extended by the DNM tool (e.g., the DNM tool's application code) to include an embedded, structured PLM-focused XML data island within each file.

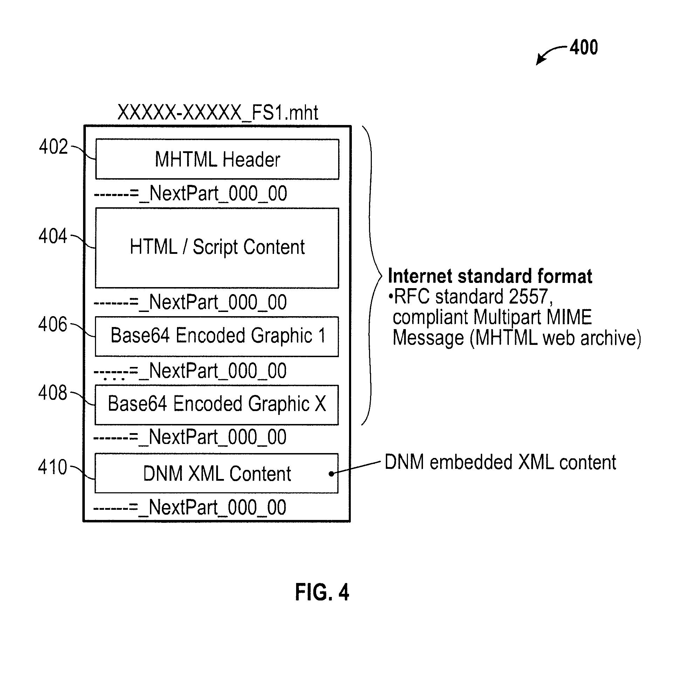

Referring to FIG. 4, an example of a DNM file structure 400 is shown. As shown, the file structure 400 may be based on an mht format and may include modules or components 402, 404, 406, and 408 compliant with a multipart MIME message (MHTML web archive). The component 402 may implement a header (e.g., a MHTML header). The component 404 may implement content (e.g., HTML/Script content). The components 406 and 408 may implement graphics (e.g., Base64 encoded graphics).
*[001]* As shown in FIG. 4, the file structure 400 may include a data island 410. The data island 410 may implement a PLM-focused XML data island. The data or content 410 may be extracted upon a check-in of a file associated with the file structure 400 for potential loading into one or more PLM databases or tables (not shown in FIG. 4). The data island 410 may be configured to provide functionalities of PLM-focused XML data insertion and extraction.

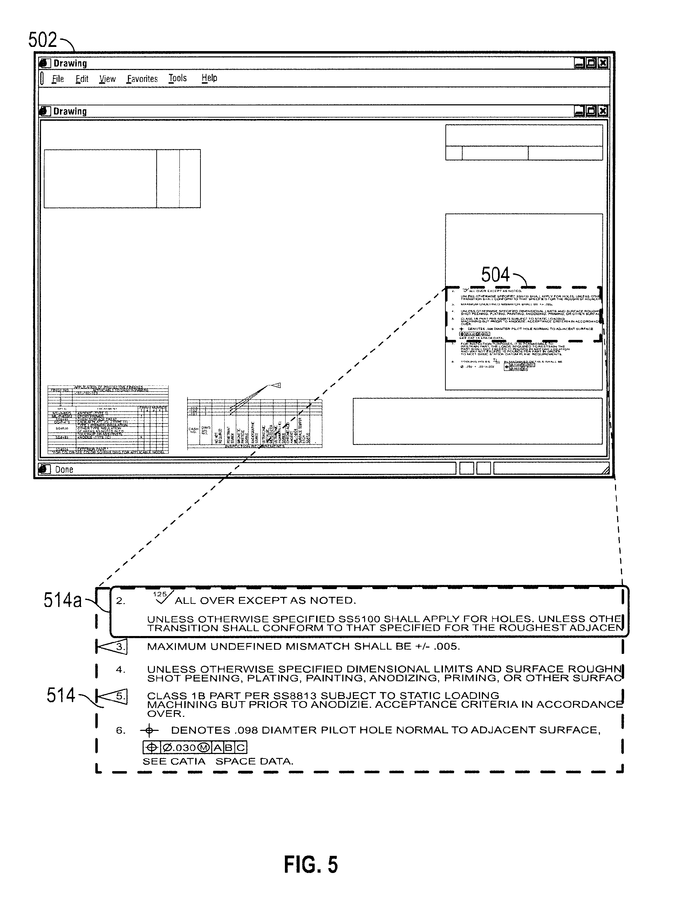

Referring to FIG. 5, an exemplary drawing sheet 502 in accordance with one or more embodiments of the disclosure is shown. The drawing sheet 502 may include one or more notes, such as notes indicated by a box 504. A blown-up or closer view of the box 504 is shown in connection with box 514. A portion of the note 504/514 is shown via box 514a in FIG. 5.

A processing of the drawing sheet 502 in accordance with one or more file structures (e.g., file structure 400 of FIG. 4) may generate one or more files. For example, a processing of the drawing sheet 502 may generate an output mht file.

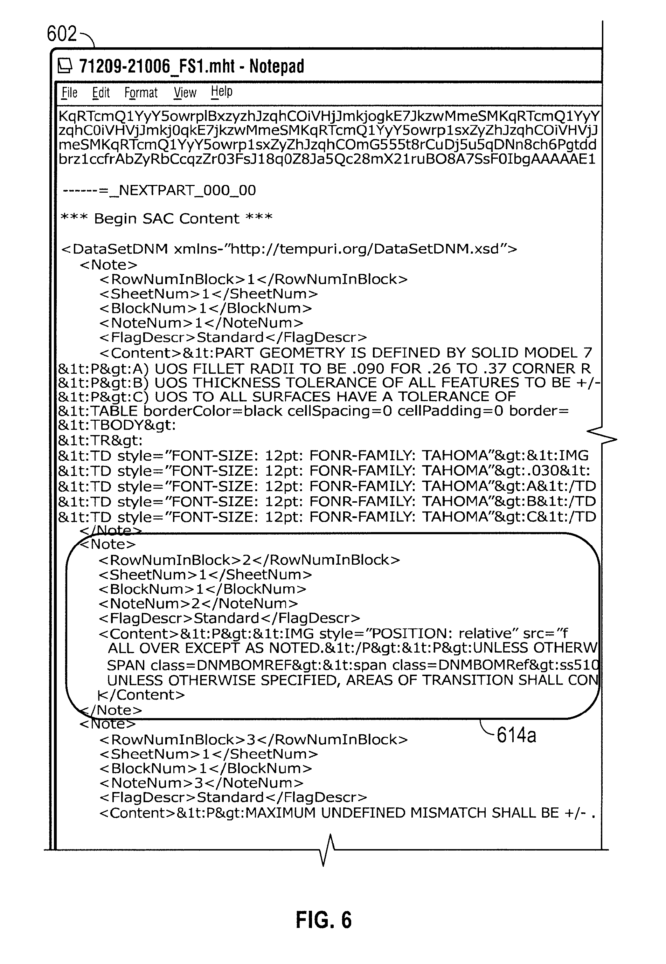

FIG. 6 illustrates an exemplary structured file 602 in accordance with one or more embodiments of the disclosure. The file 602 may be generated as a result of processing the drawing sheet 502 of FIG. 5, and may be representative of source code in an mht format. A portion of the file 602 is indicated in a box 614a. The content of the box 614a may be indicative of the note 514a of FIG. 5. More generally, the structured file 602 may incorporate notes included in the drawing sheet 502.

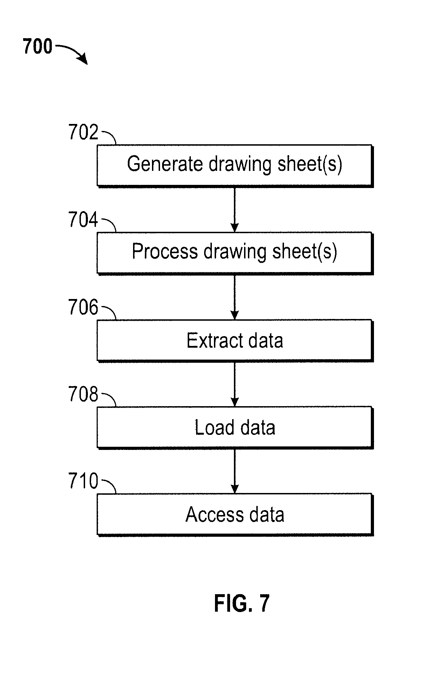

FIG. 7 illustrates a method 700 that may be used in connection with one or more entities, devices or systems, such as those described herein. The method 700 may be used to provide notes included in one or more drawing sheets to a PLM-focused tool or device.

In block 702, one or more drawing sheets may be generated. The drawing sheets may be generated using one or more tools, such as one or more CAD tools. The drawing sheets may include one or more notes, where the one or more notes may include text and/or graphics.

In block 704, the drawing sheet(s) of block 702 may be processed. Processing a drawing sheet may include processing the drawing sheet in accordance with a file structure, such as a DNM file structure, potentially in connection with a file format (e.g., an MHTML or mht file format). The file structure or format may be extended to include a PLM-focused (XML) data island.

In block 706, the data island of block 704 may be extracted. For example, the extraction may occur in response to a saving of a file or an upload or check-in event. The extracted data or data island may include data indicative of one or more notes included in the generated drawing sheet of block 702.

In block 708, the data extracted in block 706 may be loaded into a PLM tool or device, such as a PLM database or table.

In block 710, the loaded data of block 708 may be accessed. The data may be accessed for any number of reasons, such as data mining, replenishing inventory, error checking, etc.

In some embodiments, the loaded data of block 708 may be accessed in block 710 to populate a second drawing sheet. For example, notes prepared with respect to a first drawing sheet may be incorporated into a second drawing sheet. In this manner, accuracy in the notes may be carried over from a first product or design to a second product or design.

In some embodiments, the loaded data of block 708 may be accessed in block 710 to compare the loaded data against the drawing sheet of block 702 or block 704. For example, if the processing or data extraction of blocks 704 and 706 modifies (e.g., truncates) a note included in the drawing sheet, the comparison may be performed for error-checking purposes. The comparison may generate an output as to whether a deviation (if any) between the note included in the drawing sheet and the loaded data exceeds a threshold.

In some embodiments, the loaded data of block 708 may be accessed in block 710 in order to perform a search. For example, if the loaded data of block 708 is part of a database, the database may be searched, potentially in response to one or more commands, in order to identify instances of a particular note. The identified instances may be output. Such a search may be used to identify products or designs that include the particular note. Such a search may also be used to maintain an appropriate level of inventory if the note pertains to a particular component or device incorporated into, e.g., a product.

The method 700 is illustrative. In some embodiments, one or more of the blocks or operations (or portions thereof) may be optional. In some embodiments, additional operations not shown may be included. In some embodiments, the operations may execute in an order or sequence different from what is shown.

Embodiments of the disclosure may be tied to one or more particular machines. For example, one or more devices, apparatuses, systems, or architectures may be configured to store notes (e.g., finishes and inspection data) in one or more structured files (e.g., an XML file, optionally within a DNM file). The file(s), or data associated therewith, may be extracted to one or more PLM tools for loading into one or more PLM database tables. The data may be accessed in accordance with one or more uses or applications.

Embodiments of the disclosure may provide for continued use of conventional looking text-and-graphics drawing sheets, while simultaneously providing for structured storage of data associated with the text-and-graphics in a PLM tool or application. As such, data mining, error checking, business intelligence, and other activities can be conducted on data that has been traditionally locked within, or restricted to, CAD files.

As described herein, in some embodiments various functions or acts may take place at a given location and/or in connection with the operation of one or more apparatuses, systems, or devices. For example, in some embodiments, a portion of a given function or act may be performed at a first device or location, and the remainder of the function or act may be performed at one or more additional devices or locations.

Embodiments may be implemented using one or more technologies. In some embodiments, an apparatus or system may include one or more processors, and memory storing instructions that, when executed by the one or more processors, cause the apparatus or system to perform one or more methodological acts as described herein. Various mechanical components known to those of skill in the art may be used in some embodiments.

Embodiments may be implemented as one or more apparatuses, systems, and/or methods. In some embodiments, instructions may be stored on one or more computer-readable media, such as a transitory and/or non-transitory computer-readable medium. The instructions, when executed, may cause an entity (e.g., an apparatus or system) to perform one or more methodological acts as described herein.

Aspects of the disclosure have been described in terms of illustrative embodiments thereof. Numerous other embodiments, modifications and variations within the scope and spirit of the appended claims will occur to persons of ordinary skill in the art from a review of this disclosure. For example, one of ordinary skill in the art will appreciate that the steps described in conjunction with the illustrative figures may be performed in other than the recited order, and that one or more steps illustrated may be optional.

## Claims

1. A method comprising:
processing, by a computing device comprising a processor, a drawing sheet in accordance with a file structure, wherein the drawing sheet comprises a note including a graphic;
extracting, by the computing device, data from the drawing sheet based on the processing, the data comprising a representation of the graphic included in the note; and
loading, by the computing device, the data into at least one of a product lifecycle management tool and a product data management tool.

2. The method of claim 1, further comprising:
generating, by the computing device, the drawing sheet using at least one of a computer aided design tool and a computer aided drawing tool (CAD tool); and
causing, by the computing device, the drawing sheet to be output to at least one output device.

3. The method of claim 1 or 2, wherein the file structure adheres to a Multipurpose Internet Mail Extensions Hypertext Markup Language (MHTML) file format; in particular the MHTML format being extended to comprise a structured PLM-focused extensible markup language (XML) data island.

4. The method of any of claims 1 to 3, further comprising:
comparing, by the computing device, the loaded data against the note in the drawing sheet; and
providing, by the computing device, an indication of whether the loaded data matches the note in the drawing sheet within a threshold based on the comparison.

5. The method of any of claims 1 to 4, wherein the note includes at least one of a textual note and an annotation, and wherein the data comprises a representation of the at least one of the textual note and the annotation; in particular the at least one of the textual note and the annotation comprising at least one of an engineering finish and an inspection requirement.

6. The method of any of claims 1 to 5, further comprising:
performing a data mining of a database based on the loaded data; and
populating a second drawing sheet with the note based on the data mining.

7. The method of any of claims 1 to 6, further comprising:
performing a search of a database for the note based on the loaded data; and
outputting an identification of one or more instances where the note appears.

8. An apparatus comprising:
at least one processor; and
memory having instructions stored thereon that, when executed by the at least one processor, cause the apparatus to:
process a drawing sheet in accordance with a file structure, wherein the drawing sheet comprises a note including a graphic,
extract data from the drawing sheet based on the processing, the data comprising a representation of the graphic included in the note, and
load the data into at least one of a product lifecycle management tool and a product data management tool.

9. The apparatus of claim 8, further comprising:
a user interface configured to receive input to generate the drawing sheet.

10. The apparatus of claim 9, wherein the user interface is configured to support at least one of a computer aided design tool and a computer aided drawing tool (CAD tool) to receive the input, and wherein the instructions, when executed by the at least one processor, cause the apparatus to:
output the drawing sheet to an output device associated with the user interface.

11. The apparatus of any of claims 8 to 10, wherein the file structure adheres to a Multipurpose Internet Mail Extensions Hypertext Markup Language (MHTML) file format.

12. The apparatus of claim 11, wherein the MHTML format is extended to comprise a structured extensible markup language (XML) data island.

13. The apparatus of any of claims 8 to 12, wherein the instructions, when executed by the at least one processor, cause the apparatus to:
access the data from one of the product lifecycle management tool and the product data management tool to perform at least one of data mining and automated error checking.

14. The apparatus of any of claims 8 to 13, wherein the note includes at least one of a textual note and an annotation, and wherein the data comprises a representation of the at least one of the textual note and the annotation.

15. A non-transitory computer-readable medium comprising instructions that, when executed, cause the apparatus according to any of claims 8 to 14 to carry out the method of any of claims 1 to 7.
